Europäisches Patentamt

European Patent Office

Office européen des brevets

(19)

(11) Numéro de publication : **0 449 200 B1**

(12) ## FASCICULE DE BREVET EUROPEEN

(45) Date de publication du fascicule du brevet :
**08.11.95 Bulletin 95/45**

(51) Int. Cl.⁶ : **H03F 1/32,** H03F 3/30,
H03F 3/45

(21) Numéro de dépôt : **91104756.1**

(22) Date de dépôt : **26.03.91**

(54) **Etage différentiel de sortie d'équipement électronique.**

(30) Priorité : **29.03.90 FR 9004032**

(43) Date de publication de la demande :
**02.10.91 Bulletin 91/40**

(45) Mention de la délivrance du brevet :
**08.11.95 Bulletin 95/45**

(84) Etats contractants désignés :
**AT BE CH DE ES FR GB IT LI NL SE**

(56) Documents cités :
**FR-A- 2 458 948
GB-A- 2 010 039
US-A- 3 990 020
ELEKTRONIK, vol. 35, no. 10, mai 1986,
MÜNCHEN, DE, page 102; Frantisek Michele:
"U/I-Wandler mit Übertragungsfaktor"**

(73) Titulaire : **ALCATEL CIT
12 Rue de la Baume
F-75008 Paris (FR)**

(72) Inventeur : **Bouzidi, Jean-Pierre
Route de Kermaria,
Sulard
F-22300 Lannion (FR)**

(74) Mandataire : **Weinmiller, Jürgen et al
Lennéstrasse 9
Postfach 24
D-82336 Feldafing (DE)**

EP 0 449 200 B1

## Description

La présente invention concerne les équipements électroniques et a plus particulièrement pour objet un étage différentiel de sortie de tels équipements.

Les étages différentiels de sortie d'équipements électroniques comportent habituellement un transformateur permettant d'obtenir une tension de sortie différentielle indépendante des conditions de raccordement de leurs accès de sortie.

Le principal problème posé par un tel transformateur, notamment dans le cas d'équipements audiofréquence, est sa taille, ce problème étant aggravé par le fait que ses caractéristiques, en bande passante, en variation du niveau de sortie avec la charge, et en distorsion harmonique sont d'autant meilleures qu'il est encombrant. Un étage de sortie audio sans transformateur est divulgué dans le document GB-A 2 010 039.

On connaît également des étages différentiels de sortie d'équipements électroniques, notamment audiofréquence, ne comportant pas de transformateur. Ils sont, à l'inverse des précédents, peu encombrants mais ont pour inconvénient que le niveau de sortie dépend du raccordement effectué. Par exemple, si l'une des sorties est mise à la masse, chaque accès de sortie contribuant pour moitié à la tension de sortie différentielle, celle-ci est divisée par deux.

La présente invention a pour objet un étage différentiel de sortie d'équipement électronique ne comportant pas de transformateur et permettant néanmoins d'obtenir une même tension de sortie différentielle quelles que soient les conditions de raccordement de ses accès de sortie : accès relié à la masse, accès à vide, accès chargés.

La présente invention a également pour objet un étage différentiel de sortie d'équipement électronique audiofréquence permettant d'éviter, dans le cas d'une mise à la masse d'un accès de sortie, une éventuelle distorsion de la tension différentielle de sortie.

La présente invention a pour objet un étage différentiel de sortie d'équipement électronique, constitué sous forme d'un quadripôle comportant deux voies reliant chacune une entrée à une sortie, essentiellement caractérisé en ce qu'il comporte des moyens d'élaboration d'une tension de contre-réaction de chaque voie sur l'autre, et des moyens pour former pour chaque voie, une tension de sortie de cette voie égale à une combinaison linéaire, identique pour chacune des voies, de la tension d'entrée de cette voie et desdites tensions de contre-réaction.

D'autres objets et caractéristiques de la présente invention apparaîtront plus clairement à la lecture de la description suivante d'exemples de réalisation, faite en relation avec les dessins ci-annexés dans lesquels :
- la figure 1 est un schéma de principe d'un étage différentiel de sortie suivant l'invention suivant un premier mode de réalisation;
- la figure 2 est un schéma détaillé d'un exemple de ce premier mode de réalisation;
- la figure 3 est un schéma détaillé d'un étage différentiel de sortie suivant un deuxième mode de réalisation de l'invention;
- la figure 4 est une représentation symbolique de l'étage différentiel de sortie selon la figure 3.

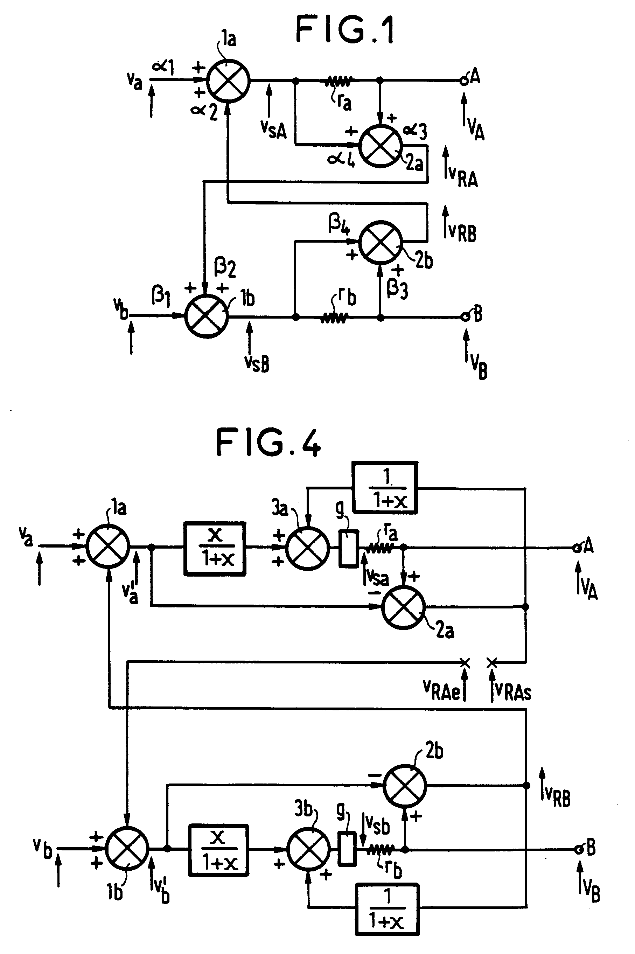

L'étage différentiel représenté sur la figure 1 est constitué sous forme de quadripôle dont les accès de sortie sont repérés A et B, la tension différentielle de sortie étant égale à $V_A - V_B$, où $V_A$ désigne la tension au point A, et $V_B$ la tension au point B. Les accès d'entrée de ce quadripôle sont repérés "a" et "b", $v_a$ et $v_b$ désignant respectivement la tension en ces points.

Ce quadripôle comporte, sur la voie a-A reliant les accès "a" et A, un sommateur la, à deux entrées à coefficients de pondération respectifs $\alpha1$ et $\alpha2$, fournissant une tension de sortie $V_{sA}$ égale à une combinaison linéaire de ses tensions d'entrée, telle que :

$$v_{sA} = \alpha_1 v_a + \alpha_2 v_{RB} \quad (1)$$

où $v_{RB}$, désignant une tension de contre-réaction de la voie b-B sur la voie a-A, est obtenue en sortie d'un sommateur 2b, à deux entrées à coefficients de pondération respectifs $\beta_3$ et $\beta_4$, fournissant une tension de sortie égale à une combinaison linéaire de ses tensions d'entrée, telle que :

$$v_{RB} = \beta_3 V_B + \beta_4 v_{sB} \quad (2)$$

dans laquelle la tension $v_{sB}$ est la tension obtenue en sortie d'un sommateur 1b, à deux entrées à coefficients de pondération respectifs $\beta_1$ et $\beta_2$, monté sur la voie b-B de façon analogue au sommateur la sur la voie a-A, et fournissant une tension de sortie $v_{sB}$ égale à une combinaison linéaire de ses tensions d'entrée, telle que :

$$v_{sB} = \beta_1 v_b + \beta_2 v_{RA} \quad (3)$$

où $v_{RA}$, désignant une tension de contre-réaction de la voie a-A sur la voie b-B, est obtenue en sortie d'un sommateur 2a, à deux entrées à coefficients de pondération respectifs $\alpha_3$ et $\alpha_4$, fournissant une tension de sortie égale à une combinaison linéaire de ses tensions d'entrée, telle que :

$$v_{RA} = \alpha_3 V_A + \alpha_4 v_{sA} \quad (4)$$

Une résistance $r_a$ est par ailleurs disposée sur la voie a-A entre le point commun à la sortie du sommateur 1a et à l'entrée du sommateur 2a affectée du coefficient $\alpha_4$, et l'entrée du sommateur 2a affectée du coefficient $\alpha_3$.

Une résistance $r_b$ est de même disposée sur la voie b-B entre le point commun à la sortie du sommateur 1b et à l'entrée du sommateur 2b affectée du coefficient $\beta_4$, et l'entrée du sommateur 2b affectée du coefficient $\beta_3$.

Il découle des relations (1), (2), (3), (4) les relations suivantes :

$$\alpha_3\, V_A \;=\; -\,\alpha_1\alpha_4\, v_a \;-\; \alpha_2\alpha_4\, v_{RB} \;+\; v_{RA}$$
$$\beta_3\, V_B \;=\; -\,\beta_1\beta_4\, v_b \;-\; \beta_2\beta_4\, v_{RA} \;+\; v_{RB}$$

et par soustraction

$$\alpha_3\, V_A \;-\; \beta_3 V_B \;=\; -\,\alpha_1\alpha_4 v_a \;+\; \beta_1\beta_4\, v_b$$
$$-\,\alpha_2\,\alpha_4\, v_{RB} \;+\; \beta_2\,\beta_4\, v_{RA}$$
$$-\, v_{RB} \;+\; v_{RA}$$

Avec les conditions suivantes sur les coefficients $\alpha_1$ à $\alpha_4$ et $\beta_1$ à $\beta_4$ :

$$\alpha_3 \;=\; \beta_3 \;=\; \gamma$$
$$\frac{\alpha_1\,\alpha_4}{\gamma} \;=\; \frac{\beta_1\,\beta_4}{\gamma} \;=\; -\,k$$
$$\alpha_4 \cdot \alpha_2 \;=\; -\,1$$
$$\beta_4 \cdot \beta_2 \;=\; -\,1$$

où $\gamma$ et k sont des constantes positives ou négatives, les tensions de sortie $V_A$ et $V_B$ des voies a-A et b-B sont alors chacune égale à une même combinaison linéaire de la tension d'entrée de leur voie et des tensions de contre-réaction $v_{RA}$ et $v_{RB}$ et leur différence s'écrit:

$$V_A \;-\; V_B \;=\; k(v_a \;-\; v_b) \qquad (5)$$

Cette relation montre que la tension de sortie différentielle $V_A - V_B$ ne dépend alors, pour k donné, que de la tension différentielle d'entrée $v_a - v_b$ et est donc la même quelles que soient les conditions de raccordement des accès de sortie A et B.

Notamment lorsque la sortie B est mise à la masse, on obtient toujours $V_A = k(v_a - v_b)$, $V_B$ étant égale à 0, et de même lorsque la sortie A est mise à la masse, on obtient toujours $V_B = k(v_b - v_a)$, $V_A$ étant égal à 0.

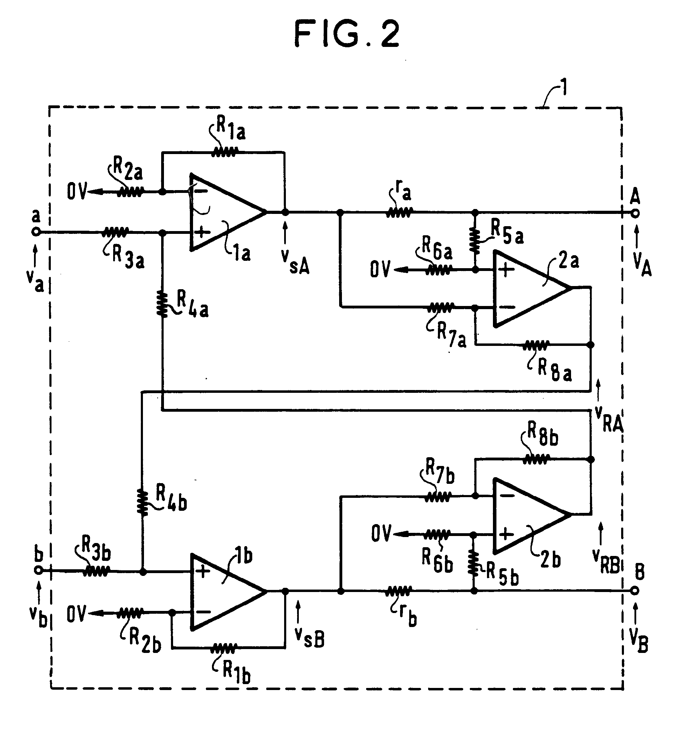

Un exemple de réalisation détaillé de l'étage de sortie différentiel représenté sur la figure 1, permettant d'obtenir la relation $V_A - V_B = k(v_a - v_b)$, est représenté sur la figure 2.

Dans cet exemple de réalisation, le sommateur 1a est un amplificateur différentiel monté en additionneur au moyen d'un ensemble de résistances $R_{1a}$, $R_{2a}$, $R_{3a}$, $R_{4a}$.

Le sommateur 1b est de même un amplificateur différentiel monté en additionneur au moyen d'un ensemble de résistances $R_{1b}$, $R_{2b}$, $R_{3b}$, $R_{4b}$.

Le sommateur 2a est un amplificateur différentiel monté en soustracteur au moyen d'un ensemble de résistances $R_{5a}$, $R_{6a}$, $R_{7a}$, $R_{6a}$.

Le sommateur 2b est de même un amplificateur différentiel monté en soustracteur au moyen d'un ensemble de résistances $R_6b$, $R_{6b}$, $R_{7b}$, $R_{8b}$.

L'amplificateur différentiel 1a est plus précisément monté de la façon suivante. Sur son entrée additive, repérée "+", sont appliquées d'une part la tension d'entrée $v_a$, à travers la résistance $R_{3a}$, et d'autre part la tension de contre-réaction $v_{RB}$, à travers la résistance $R_{4a}$. Sur son entrée soustractive, repérée "-", sont appliqués d'une part le potentiel de référence, repéré OV, à travers la résistance R2a, d'autre part sa propre tension de sortie $v_{sA}$, à travers la résistance de contre-réaction $R_{1a}$.

L'amplificateur différentiel 2a est monté de la façon suivante. Sur son entrée additive sont appliqués d'une part le potentiel de référence OV, à travers la résistance $R_{6a}$, d'autre part la tension de sortie $V_A$, à travers la résistance $R_{5a}$. Sur son entrée soustractive sont appliquées d'une part la tension $V_{sA}$ de sortie de l'amplificateur différentiel 1a, à travers la résistance $R_{7a}$, d'autre part sa propre tension de sortie, à travers la résistance de contre-réaction $R_{8a}$.

Le montage des amplificateurs différentiels 1b et 2b est obtenu de façon analogue à celui qui vient d'être décrit pour les amplificateurs 1a et 2a, en remplaçant les indices "a" et "A" par les indices "b" et B. On notera que les tensions "d'offset" des amplificateurs peuvent être éliminées en plaçant des condensateurs en série avec les résistances $R_{4a}$ et $R_{4b}$.

La résistance $r_a$ est par ailleurs disposée sur la voie a-A entre les bornes des résistances $R_{6a}$ et $R_{7a}$.

La résistance $r_b$ est de même disposée sur la voie b - B entre les bornes des résistances $R_{6b}$ et $R_{7b}$.

Les valeurs des résistances utilisées dans ce montage sont telles que

$R_{1a} = R_{2a}$
$R_{3a} = R_{4a}$
$R_{5a} = R_{6a}$
$R_{7a} = R_{8a}$

$R_{1b} = R_{2b}$
$R_{3b} = R_{4b}$
$R_{5b} = R_{6b}$
$R_{7b} = R_{8b}$

Dans ces conditions les relations (1), (2), (3), (4) sont vérifiées avec

$\alpha_1 = \alpha_2 = \alpha_3 = \beta_1 = \beta_2 = \beta_3 = 1$ et $\alpha_4 = \beta_4 = -1$ les tensions de sortie $V_A$ et $V_B$ des voies a-A et b-B s'écrivent

$$V_A = v_a + (v_{RB} + v_{RA})$$
$$V_B = v_b + (v_{RA} + v_{RB})$$

et leur différence s'écrit :

$$V_A - V_B = v_a - v_b$$

la constante k étant alors égale à 1.

Avec le montage de la figure 2 il peut cependant se produire une distorsion de la tension différentielle de sortie lorsqu'un des accès de sortie est mis à la masse.

En effet, dans le cas d'une mise à la masse d'un des accès de sortie, l'accès B par exemple, la sortie de l'amplificateur correspondant, soit dans l'exemple considéré l'amplificateur 1b, se trouve reliée à la masse à travers une résistance très faible. La tension $v_b$ étant inchangée, le courant demandé, $v_{sB}/rb$ égal à $(v_b + v_{RA})/r_b$, peut devenir supérieur au courant maximal que l'amplificateur 1b est capable de délivrer, ce qui entraîne une limitation de la tension par $v_{sB}$ fournie par celui-ci qui n'est plus alors égale à la somme des tensions $v_b$ et $v_{RA}$ et des distorsions apparaissent alors sur la sortie du montage restée active, en l'occurence sur la sortie A. Dans certains cas il peut même se produire une détérioration de l'amplificateur concerné.

Une solution pour s'affranchir de cet inconvénient serait de surdimensionner les amplificateurs 1a et 1b.

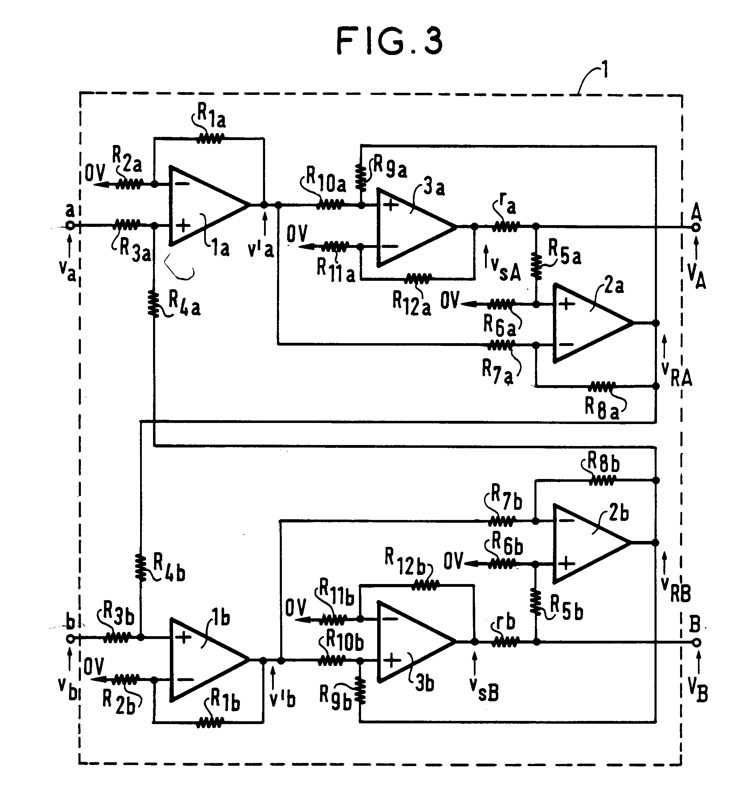

Une autre solution, plus intéressante, pour s'affranchir de cet inconvénient est fournie par le montage représenté sur la figure 3.

Ce montage comporte, outre les éléments du montage de la figure 2, repérés par les mêmes références, deux amplificateurs différentiels 3a et 3b insérés respectivement sur les voies a-A et b-B, respectivement en série avec la résistance ra, entre les bornes des résistances $R_{5a}$ et $R_{7a}$, et en série avec la résistance rb, entre les bornes des résistances $R_{5b}$ et $R_{7b}$.

Les amplificateurs différentiels 3a et 3b sont montés de manière à tendre à annuler leur tension de sortie lorsque l'accès de sortie correspondant du montage est mis à la masse, tout en évitant une saturation de ces amplificateurs différentiels.

L'amplificateur 3a est plus précisément monté de la façon suivante. Son entrée additive est connectée d'une part à la sortie de l'amplificateur 1a par l'intermédiaire d'une résistance $R_{10a}$ et d'autre part à la sortie de l'amplificateur 2a par l'intermédiaire d'une résistance $R_{9a}$. Son entrée soustractive est connectée d'une part au potentiel de référence OV par l'intermédiaire d'une résistance $R_{11a}$ et d'autre part à sa propre sortie par l'intermédiaire d'une résistance de contre-réaction $R_{12a}$.

L'amplificateur 3b est monté de façon analogue à ce qui vient d'être décrit pour l'amplificateur 3a, en remplaçant les indices "a" par les indices "b".

On obtient alors pour les amplificateurs 3a et 3b les équations suivantes, en désignant par $v_{sA}$ et $v_{sB}$ les tensions de sortie respectives des amplificateurs 3a et 3b et par $v'_a$ et $v'_b$ respectivement la tension de sortie des amplificateurs 1a et 1b :

$$\frac{v'_a R_{9a} + v_{RA} R_{10a}}{R_{9a} + R_{10a}} = v_{sA} \frac{R_{11a}}{R_{11a} + R_{12a}} \quad (6)$$

$$\frac{v'_b R_{9b} + v_{RB} R_{10b}}{R_{9b} + R_{10b}} = v_{sB} \frac{R_{11b}}{R_{11b} + R_{12b}} \quad (7)$$

En posant :

$$1 + \frac{R_{12a}}{R_{11a}} = g_a$$

$$\frac{R_{9a}}{R_{10a}} = x_a$$

$$1 + \frac{R_{12b}}{R_{11b}} = g_b$$

$$\frac{R_{9b}}{R_{10b}} = x_{b'}$$

les équations (6) et (7) deviennent :

$$v_{sA} = v'_a \frac{x_a}{1 + x_a} g_a + v_{RA} \frac{1}{1 + x_a} g_a \quad (8)$$

4

$$v_{sB} = v'_b \frac{x_b}{1 + x_b} g_b + v_{RB} \frac{1}{1 + x_b} g_b \quad (9)$$

Les équations de fonctionnement des amplificateurs 1a et 2a s'écrivent :

$$v_a + v_{RB} = v'_a \quad (10)$$
$$v_a' + v_{RA} = V_A \quad (11)$$

et les équations de fonctionnement des amplificateurs 1b et 2b :

$$v_b + v_{RA} = v'_b \quad (12)$$
$$v'_b + v_{RB} = V_B \quad (13)$$

On retrouve, à partir des équations (10) et (11) et des équations (12) et (13), comme dans le cas de montage de la figure 2

$$V_A = v_a + (v_{RB} + v_{RA})$$
$$V_B = v_b + (v_{RA} + v_{RB})$$

et par suite

$$V_A - V_B = v_a - v_b$$

et ceci indépendamment des valeurs de $g_a$, $g_b$, $x_a$ et $x_b$. Pour des raisons de symétrie on choisit avantageusement

$$g_a = g_b = g$$
$$x_a = x_b = x$$

En remplaçant $v_{RA}$ et $v_{RB}$ par les expressions :

$$v_{RA} = V_A - (v_a + v_{RB})$$
$$v_{RB} = V_B - (v_b + v_{RA})$$

déduites des équations (10), (11), (12) et (13) et $v'_a$ et $v'_b$ par leurs expressions données par les équations (11) et (13), dans les équations (8) et (9), on obtient alors

$$v_{sA} = (v_a + v_{RB}) \frac{gx}{1 + x} + \left[ V_A - (v_a + v_{RB}) \right] \frac{g}{1 + x} \quad (14)$$

$$v_{sB} = (v_b + v_{RA}) \frac{gx}{1 + x} + \left[ V_B - (v_b + v_{RA}) \right] \frac{g}{1 + x} \quad (15)$$

Contrairement au cas du montage de la figure 2, dans le cas d'une mise de l'un des accès de sortie, par exemple l'accès B, à la masse, c'est-à-dire donc pour $V_B = O$, on obtient : (cf équation (15) avec $V_{B=0}$) :

$$v_{sB} = (v_b + v_{RA}) \frac{gx}{1 + x} - (v_b + v_{RA}) \frac{g}{1 + x}$$

soit :

$$v_{sB} = (v_b + v_{RA}) \frac{g}{1 + x} (x - 1)$$

Les résistances R9, R10, R11, et R12 sont choisies de manière à avoir :

$x = 1 + \varepsilon$ avec $0 < \varepsilon \ll 1$
$g \simeq 2$

Dans ces conditions, la tension $v_{sB}$ est limitée à :

$$v_{sB} = (v_b + v_{RA}) \cdot \varepsilon$$

On voit que dans ce cas le courant, $v_{sB}/r_b$ égal à $(V_b + v_{RA})\varepsilon/r_b$, demandé à l'amplificateur relié à l'accès de sortie B à travers la résistance $r_b$ et qui est donc ici l'amplificateur $3_b$ est diminué du facteur $\varepsilon$ par rapport au cas du montage de la figure 2. Ceci permet d'éviter la saturation de l'amplificateur $3_b$ sans qu'il soit nécessaire de le surdimensionner.

Bien entendu, un résultat analogue est obtenu pour l'amplificateur $3_a$ en cas de mise de l'accès de sortie A à la masse.

Comme on vient de le voir, la relation :

$$V_A - V_B = v_a - v_b$$

est vérifiée indépendamment des valeurs de $x_a$ et $x_b$ et de $g_a$ et $g_b$, cependant les tensions de contre-réaction $v_{RA}$ et $v_{RB}$ étant rebouclés sur elles-mêmes, respectivement à travers les résistanes $R_{9a}$ et $R_{9b}$, et l'une sur l'autre, ce montage présente un risque d'instabilité.

La condition de stabilité est liée au gain en boucle ouverte de ces tensions de contre-réaction, calculé en absence des tensions d'entrée $v_a$ et $v_b$.

Pour que le montage reste stable, le gain en boucle ouverte T doit être tel que :

$$|T| < 1$$

Ce gain est exprimé par le rapport $v_{RAs}/v_{RAe}$ où $v_{RAs}$ est la tension de contre-réaction de sortie consécutive à une tension de contre-réaction d'entrée $v_{RAe}$ comme illustré sur la figure 4, où les amplificateurs $1_a$, $1_b$, $2_a$, $2_b$, $3_a$, $3_b$ sont représentés symboliquement par la fonction de sommation qu'ils réalisent et où sont également notés les coefficients

$$\frac{x}{1+x} \text{ et } \frac{1}{1+x}$$

appliqués aux entrées des sommateurs 3a et 3b et g appliqués à leur sortie.

Les équations décrivant le montage sont :

$$v_{RAs} = v_{RB}.F$$
$$v_{RB} = v_{RAe}.F$$

soit

$$v_{RAs}/v_{RAe} = F^2$$

où F caractérise la fonction réalisée par les sommateurs et les coefficients appliqués sur chaque voie. En posant :

$$\delta = \frac{V_A}{v_{sA}} = \frac{V_B}{v_{sB}} \text{ pour } r_a = r_b$$

On peut écrire

$$v_{RB} = v_{sB}\,\delta - v_{RAe}$$
$$v_{sB} = \frac{g}{1+x}\,v_{RB} + \frac{gx}{1+x}\,v_{RAe}$$

On en déduit

$$F = \frac{g\delta x - (1+x)}{1+x - g\,\delta}$$

La condition de stabilité est :

$$|v_{RAs}/v_{RAe}| < 1$$

ce qui revient à

$$-1 < F < 1$$

La satisfaction de cette condition conduit à deux possibilités :

$$\text{soit } \begin{cases} x > 1 \\ \text{et} \\ g\,\delta < 2 \end{cases}$$

$$\text{soit } \begin{cases} x < 1 \\ \text{et} \\ g\,\delta > 2 \end{cases}$$

L'étude de la stabilité de la boucle locale formée sur chaque voie par le rebouclage de la sortie du sommateur $2_a$ ou $2_b$ sur une entrée du sommateur $3_a$ ou $3_b$, qui peut être faite de façon analogue à celle qui vient d'être faite pour la boucle globale du montage, conduit à la condition supplémentaire :

$$g\delta < 1 + x$$

cette condition n'est compatible qu'avec la première des deux possibilités précédentes, soit

$$x > 1$$

c'est-à-dire

$$R_{9a} > R_{10a} \text{ et } R_{9b} > R_{10b}$$

$$\text{et } g\delta < 2$$

C'est-à-dire, pour $\delta$ proche de 1 (par valeur inférieure)

$$R_{12a} \leqq R_{11a} \qquad \text{et } R_{12b} \leqq R_{11b}$$

Le choix de résistances $R_{9a}$, $R_{9b}$, $R_{10a}$, $R_{10b}$, $R_{11a}$, $R_{12a}$, $R_{11b}$ et $R_{12b}$ telles que

$$\frac{R_{9a}}{R_{10a}} = 1 + \varepsilon_a \qquad \text{avec } 0 < \varepsilon_a \ll 1$$

$$\frac{R_{9b}}{R_{10b}} = 1 + \varepsilon_b \qquad \text{avec } 0 < \varepsilon_b \ll 1$$

$$\frac{R_{12a}}{R_{11a}} = 1 - \varepsilon'_a \qquad \text{avec } 0 \leqq \varepsilon'_a \ll 1$$

$$\frac{R_{12b}}{R_{11b}} = 1 - \varepsilon'_b \qquad 0 \leqq \varepsilon'_b \ll 1$$

est effectué en outre de façon à s'affranchir d'un éventuel risque de saturation des amplificateurs 1a et 1b. Pour simplifier, on considèrera le cas où $\varepsilon_a = \varepsilon_b$ et $\varepsilon'_a = \varepsilon_b'$

soit

$$v = v_a = -v_b$$

avec par exemple $v > 0$

Dans le cas de conditions de fonctionnement symétriques pour les deux voies a-A et b-B, la fonction F ayant la même valeur pour les deux voies, les tensions $v'_a$ et $v'_b$ peuvent s'écrire :

$$v'_a = v \frac{1}{1 + F}$$

$$v'b = -v \frac{1}{1 + F}$$

Pour éviter un éventuel risque de saturation des amplificateurs 1a et 1b, les tensions $v'_a$ et $v'_b$ ne doivent pas dépasser 2v en valeur absolue, ce qui conduit, en tenant compte de la condition de stabilité

$$-1 < F < 1,$$

à la condition

$$-\frac{1}{2} \leqq F < 1$$

Dans le cas où l'un des accès de sortie, l'accès B par exemple, est mis à la masse, la fonction F relative à la voie B est égale à -1, le rapport $V_B/v_{sB}$ étant nul, et la valeur de la fonction F relative à la voie A est proche de celle du cas précédent. Les tensions $v'_a$ et $v'_b$ s'expriment alors par :

$$v'_a = 2v \frac{1}{1 + F}$$

$$v'_b = -v \frac{1 - F}{1 + F}$$

La condition que les tensions $v'_a$ $v'_b$ ne dépassent pas 2v en valeur absolue, impose que F ne soit pas négatif, ce qui conduit après développement et compte tenu de la condition de stabilité

$$g \, \delta < 1 + x$$

à la condition

$$g \, \delta \geqq \frac{1 + x}{x}$$

soit sensiblement pour $\delta$ proche de 1 (par valeur inférieure)

$$g \geqq \frac{1 + x}{x}$$

Dans le cas où un montage symétrique est souhaité pour l'étage différentiel de la figure 3, les résistances R1 à R12 sont respectivement choisies de mêmes valeurs mominales d'une voie à l'autre.

Du fait de l'imprécision sur les valeurs réelles des composants, il peut malgré tout y avoir des dissymétries entre les contributions de l'accès de sortie A et de l'accès de sortie B pour l'obtention de la tension différentielle de sortie $V_A - V_B$.

L'effet de cette imprécision peut-être minimisé en prenant

$$F = 0$$

c'est-à-dire

$$g\delta = \frac{1 + x}{x}$$

soit sensiblement pour $\delta$ proche de 1

$$g = \frac{1 + x}{x}$$

c'est-à-dire sensiblement

$$\frac{R12}{R11} = \frac{R10}{R9}$$

Les montages ainsi décrits ont été présentés avec des tensions $v_a$ et $v_b$ appliquées à leurs entrées "a" et "b". En prenant $v = v_a - v_b$ et en l'appliquant sur l'entrée "+" de la voie a-A et sur l'entrée "-" de la voie b-B, le comportement de ces montages reste inchangé. Cette modification évite un étage supplémentaire en amont pour la création des tensions $v_a$ et $v_b$.

Ces montages peuvent par ailleurs être complétés par des éléments de protection (transil, diode, thermistance...) en série avec les résistances $r_a$ et $r_b$, ce qui permet d'obtenir des niveaux de protection équivalents à ceux obtenus avec les montages à transformateur.

Les niveaux de protection sont par ailleurs identiques en mode commun et en mode différentiel, en raison de la symétrie de ces montages.

De plus, si les deux accès de sortie sont réunis à la masse, la tension de sortie $v_{sA}$, $v_{sB}$ de chaque voie est limitée, ce qui assure une limitation de la puissance délivrée par les amplificateurs de sortie.

## Revendications

1. Etage différentiel (1) de sortie d'équipement électronique constitué sous forme d'un quadripôle comportant deux voies (a-A, b-B) reliant chacune une entrée (a, b) à une sortie (A, B), caractérisé en ce qu'il comporte des moyens d'élaboration d'une tension de contre-réaction de chaque voie sur l'autre, et des moyens pour former pour chaque voie une tension de sortie de cette voie égale à une combinaison linéaire, identique pour chacune des voies, de la tension d'entrée de cette voie et desdites tensions de contre-réaction.

2. Etage differentiel selon la revendication 1, caractérisé en ce qu'il comporte, sur chacune des voies, un premier moyen (1a, 1b) pour ajouter à la tension d'entrée de la voie considérée la tension de contre-réaction de l'autre voie sur la voie considérée, et un second moyen (2a, 2b) pour retrancher la tension de sortie de la voie considérée de la tension de sortie du premier moyen, la tension de sortie dudit deuxième moyen constituant la tension de contre-réaction de la voie considérée sur l'autre voie.

3. Etage différentiel selon la revendication 2, caractérisé en ce que le premier moyen comporte un premier amplificateur différentiel monté en additionneur, et en ce que le deuxième moyen comporte un deuxième amplificateur différentiel monté en soustracteur.

4. Etage différentiel selon la revendication 3, caractérisé en ce qu'il comporte, sur chaque voie, entre la sortie du premier amplificateur différentiel (1a, 1b) et la sortie de la voie, un moyen supplémentaire (3a, 3b) permettant simultanément, lorsque la sortie de la voie est mise à la masse, de maintenir inchangée la tension de sortie dudit premier amplificateur différentiel, et d'obtenir une tension de sortie très faible pour ce moyen supplémentaire.

5. Etage différentiel selon la revendication 4, caractérisé en ce que ledit moyen supplémentaire comporte un moyen pour ajouter à la tension de sortie du premier amplificateur différentiel de la voie considérée la tension de contre-réaction de la voie considérée sur l'autre voie.

6. Etage différentiel selon la revendication 5, caractérisé en ce que ledit moyen pour ajouter à la tension de sortie du premier amplificateur différentiel de la voie considérée la tension de contre-réaction de la voie considérée sur l'autre voie comporte un troisième amplificateur différentiel (3a, 3b) monté au moyen d'un ensemble de résistances R9, R10, R11, R12 de manière à réaliser la relation :

$$\frac{v'R_9 + v_R R_{10}}{R_9 + R_{10}} = v_s \frac{R_{11}}{R_{11} + R_{12}}$$

où $v_s$ désigne la tension de sortie de ce troisième amplificateur différentiel, $v'$ la tension de sortie dudit premier amplificateur différentiel sur la voie considérée et $v_R$ la tension de contre-réaction de la voie considérée sur l'autre voie, avec :

$$\frac{R9}{R10} = 1 + \varepsilon \text{ (avec } 0<\varepsilon<1)$$

$$\frac{R12}{R11} = 1 - \varepsilon' \text{ (avec } 0\leqq\varepsilon'<<1)$$

7. Etage différentiel selon la revendication 6, caractérisé en ce que lesdits premier, deuxième et troisième amplificateurs différentiels des deux voies sont respectivement montés de façons identiques d'une voie à l'autre avec des résistances ayant respectivement mêmes valeurs nominales d'une voie à l'autre et lesdites résistances R9, R10, R11 et R12 de chaque voie sont choisies de telle sorte que l'on ait sensiblement :

$$\frac{R12}{R11} = \frac{R10}{R9}$$

## Patentansprüche

1. Differential-Ausgangsstufe (1) einer elektronischen Schaltung, wobei die Stufe von einem Vierpol mit zwei je einen Eingang (a, b) und einen Ausgang (A, B) verbindenden Strecken (a-A, b-B) enthält, dadurch gekennzeichnet, daß sie Mittel, um eine Gegenkopplungsspannung von jeder Strecke zur anderen zu bilden, und Mittel aufweist, um für jede Strecke eine Ausgangsspannung dieser Strecke gleich einer für beide Strecken identischen linearen Kombination der Eingangsspannung dieser Strecke und der Gegenkopplungsspannungen zu erzeugen.

2. Differentialstufe nach Anspruch 1, dadurch gekennzeichnet, daß sie für jede der Strecken ein erstes Mittel (1a, 1b), das der Eingangsspannung der betrachteten Strecke die Gegenkopplungsspannung der anderen Strecke auf der betrachteten Strecke hinzufügt, und ein zweites Mittel (2a, 2b) aufweist, um die Ausgangsspannung der betrachteten Strecke von der Ausgangsspannung des ersten Mittels abzuziehen, wobei die Ausgangsspannung des zweiten Mittels die Gegenkopplungsspannung der betrachteten Strecke für die andere Strecke bildet.

3. Differentialstufe nach Anspruch 2, dadurch gekennzeichnet, daß das erste Mittel einen ersten Differentialverstärker aufweist, der als Addierer geschaltet ist, und daß das zweite Mittel einen zweiten Differentialverstärker aufweist, der als Subtrahierglied geschaltet ist.

4. Differentialstufe nach Anspruch 3, dadurch gekennzeichnet, daß sie auf jeder Strecke zwischen dem Ausgang des ersten Differentialverstärkers (1a, 1b) und dem Ausgang der Strecke ein zusätzliches Mittel (3a, 3b) aufweist, das zugleich, wenn der Ausgang der Strecke an Masse liegt, die Ausgangsspannung des ersten Differentialverstärkers unverändert hält und eine sehr geringe Ausgangsspannung für dieses zusätzliche Mittel zu erhalten erlaubt.

5. Differentialstufe nach Anspruch 4, dadurch gekennzeichnet, daß das zusätzliche Mittel ein Mittel aufweist, um der Ausgangsspannung des ersten Differentialverstärkers der betrachteten Strecke die Gegenkopplungsspannung der betrachteten Strecke für die andere Strecke hinzuzufügen.

6. Differentialstufe nach Anspruch 5, dadurch gekennzeichnet, daß das Mittel, um der Ausgangsspannung des ersten Differentialverstärkers der betrachteten Strecke die Gegenkopplungsspannung der betrachteten Strecke für die andere Strecke hinzuzufügen, einen dritten Differentialverstärker (3a, 3b) enthält, der aufgrund einer Beschaltung mit Widerständen $R_9$, $R_{10}$, $R_{11}$, $R_{12}$ zur Implementierung der folgenden Gleichung ausgebildet ist:

$$\frac{v'R_9 + v_R R_{10}}{R_9 + R_{10}} = v_s \frac{R_{11}}{R_{11} + R_{12}}$$

wobei $v_s$ die Ausgangsspannung dieses dritten Differentialverstärkers, $v'$ die Ausgangsspannung des ersten Differentialverstärkers auf der betrachteten Strecke und $v_R$ die Gegenkopplungsspannung der betrachteten Strecke für die andere Strecke bedeutet und wobei gilt

$$R_9/R_{10} = 1 + \varepsilon \text{ (mit } 0 < \varepsilon < 1)$$
$$R_{12}/R_{11} = 1 - \varepsilon' \text{ (mit } 0 \leqq \varepsilon' << 1).$$

7. Differentialstufe nach Anspruch 6, dadurch gekennzeichnet, daß die drei Differentialverstärker der beiden Strecken bezüglich der beiden Strecken gleich beschaltet sind, d.h. mit Widerständen gleicher Nennwerte, und daß die Widerstände $R_9$, $R_{10}$, $R_{11}$ und $R_{12}$ jeder Strecke so gewählt sind, daß im wesentlichen folgende Beziehung gilt:

$$R_{12}/R_{11} = R_{10}/R_9$$

## Claims

1. A differential output stage (1) for electronic equipment, the output stage comprising a two-port network having two paths (a-A, b-B), each connecting an input terminal (a, b) to an output terminal (A, B), the stage being characterized in that it comprises means for generating a negative feedback voltage from each path for application to the other, and means for providing an output voltage in each path equal to an identical linear combination in each path, of the input voltage to the path and of the negative feedback voltage from the other path.

2. A differential stage according to claim 1, characterized in that each of its paths includes first means (1a, 1b) for adding together the input voltage of the path under consideration with the negative feedback voltage from the other path, and second means (2a, 2b) for subtracting the output voltage from the path in question from the output voltage of the first means, the output voltage of said second means constituting the negative feedback voltage from the path in question for application to the other path.

3. A differential stage according to claim 2, characterized in that the first means includes a first differential amplifier connected as an adder, and in that the second means includes a second differential amplifier connected as a subtractor.

4. A differential stage according to claim 3, characterized in that it includes, in each path, between the output from the first differential amplifier (1a, 1b) and the output from the path, additional means (3a, 3b) serving, when the output of the path is connected to ground, simultaneously to maintain the output voltage from said first differential amplifier unchanged and to obtain a very low output voltage from said additional means.

5. A differential stage according to claim 4, characterized in that said additional means includes means for adding the negative feedback voltage of the path in question for the other path to the output voltage of the first differential amplifier of the path in question.

6. A differential stage according to claim 5, characterized in that said means for adding the negative feedback voltage of the path in question for the other path to the output voltage of the first differential amplifier of the path in question comprises a third differential amplifier (3a, 3b) connected by means of a set of resistors $R_9$, $R_{10}$, $R_{11}$, and $R_{12}$ in such a manner as to satisfy the equation:

$$\frac{v'R_9 + v_R R_{10}}{R_9 + R_{10}} = v_s \frac{R_{11}}{R_{11} + R_{12}}$$

where $v_s$ designates the output voltage from said third differential amplifier, $v'$ designates the output voltage from said first differential amplifier on the path in question, and $v_R$ designates the negative feedback voltage of the path in question for the other path, with:

$$R_9/R_{10} = 1 + \varepsilon \qquad \text{(with } 0 < \varepsilon < 1\text{) and}$$
$$R_{12}/R_{11} = 1 - \varepsilon' \qquad \text{(with } 0 \leqq \varepsilon' \ll 1\text{).}$$

7. A differential stage according to claim 6, characterized in that said first, second, and third differential amplifiers in the two paths are respectively identically connected in both paths, using resistors having the same nominal resistances in both paths, and said resistors $R_9$, $R_{10}$, $R_{11}$, $R_{12}$ in the two paths being selected in such a manner that the following relationship is substantially true:

$$R_{12}/R_{11} = R_{10}/R_9$$

# FIG.1

# FIG.4

# FIG.2

# FIG.3